# EUROPEAN PATENT APPLICATION

(11) **EP 4 618 710 A1**
(43) Date of publication of application: **17.09.2025**
(21) Application number: 23895966.2
(22) Date of filing: 27.06.2023
(51) Int. Cl.: H10B 12/00

(54) **MEMORY, ELECTRONIC DEVICE, AND PREPARATION METHOD FOR MEMORY**

(30) Priority: 28.11.2022 CN 202211501780
(71) Applicant: Huawei Technologies Co., Ltd., Shenzhen, Guangdong 518129 (CN)
(72) Inventor: LI, Jingyu, Shenzhen, Guangdong 518129 (CN); JING, Weiliang, Shenzhen, Guangdong 518129 (CN); YIN, Shihui, Shenzhen, Guangdong 518129 (CN); LI, Wenkui, Shenzhen, Guangdong 518129 (CN); WANG, Zhengbo, Shenzhen, Guangdong 518129 (CN); LIAO, Heng, Shenzhen, Guangdong 518129 (CN)
(74) Representative: Epping - Hermann - Fischer
(86) International application number: PCT/CN2023/102773
(87) International publication number: WO 2024/113802

(57) **Abstract**

This application provides a memory, an electronic device, and a memory manufacturing method, and relates to the field of semiconductor storage technologies. The memory may include a memory array chip and a control circuit chip. The memory array chip includes a first substrate and a plurality of memory cells formed on the first substrate, and each memory cell includes a transistor and at least one capacitor electrically connected to the transistor. The control circuit chip includes a second substrate and a circuit structure formed on the second substrate, and the circuit structure is configured to control reading/writing of the plurality of memory cells. The plurality of memory cells and the circuit structure face each other and are electrically connected to each other through a bonding structure formed between the circuit structure and the plurality of memory cells. The memory array chip is integrated into one chip, the control circuit chip is integrated into another chip, and the two chips are bonded to form the memory. In this way, the memory array chip and the control circuit chip can be manufactured through incompatible processes.

## Description

This application claims priority to Chinese Patent Application No. 202211501780.9, filed with the China National Intellectual Property Administration on November 28, 2022 and entitled "MEMORY, ELECTRONIC DEVICE, AND MEMORY MANUFACTURING METHOD", which is incorporated herein by reference in its entirety.

### TECHNICAL FIELD

This application relates to the field of semiconductor storage technologies, and in particular, to a memory, an electronic device, a memory manufacturing method, and a memory array chip manufacturing method.

### BACKGROUND

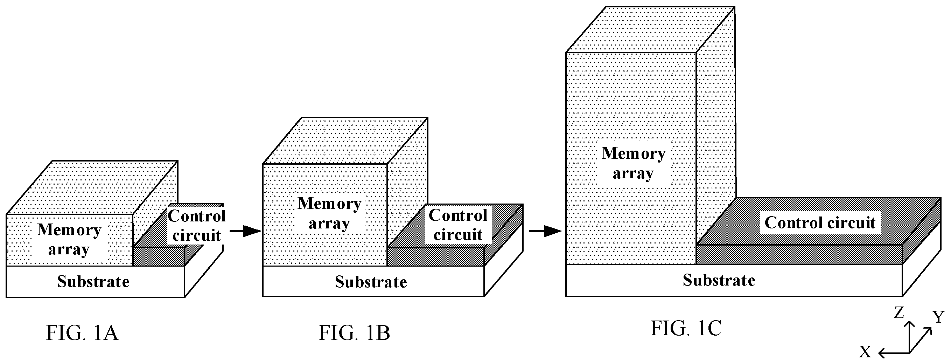

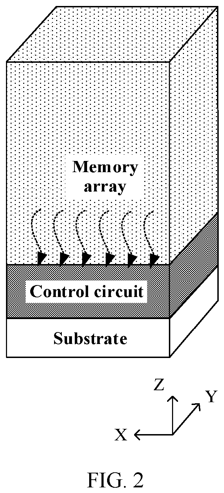

With explosive development of information, development of storage technologies points at a higher storage density, to obtain a higher storage capacity. Therefore, a 3-dimensional (3-dimensional, 3D) memory emerges. For example, for memories shown in FIG. 1A, FIG. 1B, FIG. 1C, and FIG. 2, a storage density is improved through upward 3D stacking, perpendicular to a substrate, of a memory array.

As shown in FIG. 1A to FIG. 1C and FIG. 2, the 3D memory not only includes the memory array (Array) configured to store data, but also includes a control circuit configured to control reading/writing of the memory array. In some examples, the control circuit may be referred to as a CMOS peripheral circuit.

FIG. 1A to FIG. 1C show CMOS next array (CnA) 3D memory structures. In this structure, the control circuit and the memory array are integrated on a same surface of a same chip and arranged in parallel through a manufacturing process of a chip with a 2-dimensional (2-dimensional, 2D) planar structure, where the memory array is stacked upwards perpendicular to the substrate to form the 3D structure.

For the 3D memory structure with a CnA architecture, as shown in FIG. 1A to FIG. 1C, as a stacking height (for example, in a Z direction) of the memory array increases, a proportion of an area occupied by the control circuit on the substrate also increases. This is not conducive to manufacturing a small-sized high-density storage device.

FIG. 2 shows a CMOS under array (CuA) 3D memory structure. In this structure, the control circuit is integrated under the memory array. During manufacturing, the control circuit is first manufactured, and then the memory array is manufactured above the control circuit and is stacked through upward 3D stacking to achieve high-density storage. However, in the 3D memory with a CuA architecture shown in FIG. 2, manufacturing of the memory array includes a high-temperature manufacturing process (for example, crystallization of Si needs to be performed at a high temperature). The high temperature affects performance of the control circuit that has been formed below the memory array, for example, reduces a transmission speed of the control circuit.

The manufacturing process shown in FIG. 2 may be understood as that a manufacturing process of the memory array is incompatible with a manufacturing process of the CMOS peripheral circuit. Therefore, in the structure shown in FIG. 2, although a 2-dimensional dimension of a storage device can be reduced, performance of the storage device is limited.

### SUMMARY

This application provides a memory, an electronic device, a memory manufacturing method, and a memory array manufacturing method. A main objective is to provide a structure in which a memory array chip and a control circuit chip are bonded together, so that not only a 2-dimensional area of the chip can be reduced, but also a problem of process incompatibility can be resolved.

To achieve the foregoing objective, the following technical solutions are used in embodiments of this application.

According to one aspect, this application provides a memory. The memory may include a memory array chip and a control circuit chip. The memory array chip includes a first substrate and a plurality of memory cells formed on a side of the first substrate, and each memory cell includes a transistor and at least one capacitor electrically connected to the transistor. The control circuit chip includes a second substrate and a circuit structure formed on a side of the second substrate, and the circuit structure is configured to control reading/writing of the plurality of memory cells. The plurality of memory cells and the circuit structure face each other and are electrically connected to each other through a bonding structure formed between the circuit structure and the plurality of memory cells. In addition, the transistor and the at least one capacitor are stacked in a direction perpendicular to the first substrate, and the transistor is disposed close to the bonding structure relative to the at least one capacitor.

According to the memory in this application, the plurality of memory cells are integrated into the memory array chip, and the circuit structure configured to control the reading/writing of the memory cell is integrated into the control circuit chip. The two chips are bonded together through the bonding structure, that is, the memory cell and the circuit structure are interconnected through the bonding structure.

Because the plurality of memory cells are integrated into one chip, and the circuit structure is integrated into another chip, in a manufacturing process, a process used to manufacture the plurality of memory cells may be incompatible with a process used to manufacture the circuit structure. In this way, performance of components is not affected by process incompatibility. To be specific, in the 3D memory architecture provided in this application, a process of the memory array chip and a process of the control circuit chip can be decoupled in terms of the manufacturing process. In addition, in the memory array chip in this application, the transistor and the capacitor are stacked in the direction perpendicular to the first substrate, so that more memory cells can be integrated on a unit area of the first substrate, thereby improving a storage density. In addition, in the 3D memory structure provided in this application, the memory array chip and the control circuit chip are disposed in a 3D stacked manner, so that compared with a CMOS next array (CnA) 3D memory structure, a 2-dimensional dimension/area of the entire chip-stacked structure is not large with an increase in a quantity of stacked layers of the memory array chip, and on the basis of improving the storage density, a 2-dimensional area of the chip is not increased.

In an implementation, first solder joints are formed on a side that is of the plurality of memory cells and that is away from the first substrate, second solder joints are formed on a side that is of the circuit structure and that is away from the second substrate, and the first solder joints and the second solder joints are bonded to form the bonding structure. In other words, during manufacturing, the first solder joints on the memory array chip and the second solder joints on the control circuit chip may be bonded together to form the memory with a multiple-chip-stacked structure.

In an implementation, the bonding structure is manufactured through a hybrid bonding (Hybrid Bonding) process.

In an implementation, a first conductive channel perpendicular to the first substrate is disposed on a periphery of the at least one capacitor, and each capacitor is electrically connected to the bonding structure through the first conductive channel.

Because the capacitor is disposed close to the first substrate relative to the transistor, to electrically connect the capacitor to the peripheral control circuit chip, the capacitor may be connected to the bonding structure through the conductive channel, and the conductive channel is used as an electrical connection structure. This not only has a simple structure, but also is easy to implement in a process.

In an implementation, each memory cell includes a plurality of capacitors, and each capacitor includes a first capacitor electrode, a capacitive layer, and a second capacitor electrode. A plurality of dielectric layers and a plurality of conductive layers are alternately stacked on the first substrate in the direction perpendicular to the first substrate. The second capacitor electrode penetrates the plurality of dielectric layers and the plurality of conductive layers that are alternately stacked, to form a common second capacitor electrode of the plurality of capacitors. The capacitive layer penetrates the plurality of dielectric layers and the plurality of conductive layers that are alternately stacked, to form a common capacitive layer of the plurality of capacitors, where the common capacitive layer surrounds the common second capacitor electrode. At least a part of the conductive layer surrounding a periphery of the capacitive layer forms the first capacitor electrode. Two adjacent first capacitor electrodes perpendicular to the first substrate are isolated from each other by the dielectric layer.

When there are a plurality of capacitors, in a process structure, the plurality of capacitors may share the second capacitor electrode and the capacitive layer. This not only simplifies a manufacturing process, but also simplifies the structure, thereby improving the storage density.

In an implementation, first capacitor electrodes of a plurality of capacitors arranged in parallel to the first substrate are integrated.

In some manufacturing processes, a conductive layer parallel to the first substrate may be formed, a plurality of holes are punched in the conductive layer, and each hole is filled with a capacitor material and another capacitor electrode material, so that the capacitor electrodes of the plurality of capacitors parallel to the first substrate are integrated, to form a conductive layer parallel to the first substrate.

In an implementation, the plurality of conductive layers are arranged in a stepped shape in a direction away from the first substrate, and in two adjacent conductive layers, an orthographic projection, on the first substrate, of a conductive layer away from the first substrate is located within a boundary of an orthographic projection, on the first substrate, of a conductive layer close to the first substrate; and the first conductive channel is located at an edge of the conductive layer.

The plurality of conductive layers are arranged in the stepped shape, so that accommodation space can be reserved for a conductive channel connected to a lower conductive layer (a conductive layer close to the first substrate). In addition, the first conductive channel as an electrical connection structure is disposed at the edge of the conductive layer, to fully use edge space of the conductive layer. In this way, an interconnection structure for the capacitor and the bonding structure is not complex, and the storage density can be improved.

In an implementation, a side that is of the transistor and that is close to the bonding structure has a second conductive channel perpendicular to the first substrate, and the transistor is electrically connected to the bonding structure through the second conductive channel.

In an implementation, the memory array chip further includes a first electrode line and a second electrode line, where the first electrode line is electrically connected to a gate of the transistor, the second electrode line is electrically connected to a first electrode of the transistor, and a second electrode of the transistor is electrically connected to the capacitor.

For example, the first electrode line may be a word line WL, and the second electrode line is a bit line BL. The transistor is turned on and off through the word line WL, and the memory cell is read and written through the bit line BL.

In an implementation, the first electrode and the second electrode of the transistor are arranged in the direction perpendicular to the first substrate, a channel layer of the transistor is located between the first electrode and the second electrode, and the first electrode is disposed away from the capacitor relative to the second electrode, the second electrode line and the first electrode share a same electrode layer, and the second electrode line is electrically connected to the bonding structure through the second conductive channel perpendicular to the first substrate.

Because the transistor is disposed on a side away from the first substrate, the transistor and the bonding structure may be electrically connected together through the conductive channel with a simple structure.

In an implementation, the transistor is a gate-all-around transistor.

For example, the first electrode and the second electrode of the transistor are arranged in the direction perpendicular to the first substrate, a channel layer of the transistor is located between the first electrode and the second electrode, a gate surrounds the channel layer, and the gate is isolated from the channel layer by a gate dielectric layer, thereby forming the gate-all-around transistor.

In an implementation, the memory array chip is a DRAM memory array chip, or the memory array chip is a ferroelectric memory array chip.

According to another aspect, this application further provides a memory manufacturing method. The manufacturing method includes:
providing a memory array chip and a control circuit chip, where the memory array chip includes a first substrate and a plurality of memory cells formed on a side of the first substrate, each memory cell includes a transistor and at least one capacitor electrically connected to the transistor, there are first solder joints on a side that is of the plurality of memory cells and that is away from the first substrate, the control circuit chip includes a second substrate and a circuit structure formed on a side of the second substrate, and there are second solder joints on a side that is of the circuit structure and that is away from the second substrate; and
making the plurality of memory cells and the circuit structure face each other, and bonding the first solder joints to the second solder joints, to form a bonding structure that connects the memory array chip to the control circuit chip, for the circuit structure to control reading/writing of the plurality of memory cells through the bonding structure. In this manufacturing method, the memory cell and the circuit structure are not integrated into a same chip, but are separately integrated into different chips, to form the memory array chip and the control circuit chip that are independent of each other. Then, the memory array chip and the control circuit chip are bonded, so that the control circuit controls reading/writing of the memory cell.

Therefore, when the memory cell is manufactured and the circuit structure configured to control the reading/writing of the memory cell is manufactured, process means that are incompatible with each other and that do not restrict each other may be used. In this way, process methods do not interfere with each other, and a case in which the memory cell and the circuit structure affect operating performance of each other due to the processes does not occur.

In an implementation, the first solder joint and the second solder joint are bonded through a hybrid bonding (Hybrid Bonding) process.

In an implementation, when the first solder joint is bonded to the second solder joint, a bonding temperature is lower than or equal to 450°C. For example, the bonding temperature is lower than or equal to 400°C.

When the bonding temperature is not higher than 450°C, performance of the memory array chip and performance of the control circuit chip are basically not affected.

According to still another aspect, this application further provides a memory array chip manufacturing method. The manufacturing method includes:
forming at least one capacitor on a substrate;
forming a transistor on a side that is of the at least one capacitor and that is away from the substrate, where each memory cell in a memory array chip includes the at least one capacitor and the transistor;
forming a first conductive channel perpendicular to the substrate on a periphery of the at least one capacitor, and forming a second conductive channel perpendicular to the substrate on a side that is of the transistor and that is away from the substrate; and
forming a solder joint on a side that is of the memory cell and that is away from the substrate, for the at least one capacitor to be electrically connected to the solder joint through the first conductive channel, and for the transistor to be electrically connected to the solder joint through the second conductive channel.

In the memory array manufacturing method provided in this application, the capacitor and the transistor are stacked in a direction perpendicular to the substrate. In this way, more memory cells can be formed in a unit area of the substrate, thereby improving a storage density; and the capacitor is disposed closer to the substrate relative to the transistor, the capacitor is electrically connected to the solder joint through the conductive channel with a simple structure, and the transistor is also electrically connected to the solder joint through the conductive channel with a simple structure.

In an implementation, the forming at least one capacitor on a substrate includes: alternately stacking a plurality of dielectric layers and a plurality of conductive layers on the substrate; forming vias that penetrate the plurality of dielectric layers and the plurality of conductive layers; and sequentially filling the via with a capacitor material and an electrode material, to form a capacitive layer and a capacitor electrode in the via, where the capacitive layer is formed between the capacitor electrode and a side wall of the via, to manufacture a plurality of capacitors, the capacitive layer forms a common capacitive layer of the plurality of capacitors, the capacitor electrode forms a common second capacitor electrode of the plurality of capacitors, and at least a part of the conductive layer surrounding a periphery of the capacitive layer forms a first capacitor electrode of the capacitor.

In other words, the capacitor in the memory cell is disposed close to the substrate, and the plurality of capacitors share the capacitive layer and one capacitor electrode. This simplifies a process structure, and reduces an area of each memory cell, thereby improving the storage density.

In an implementation, after the alternately stacking a plurality of dielectric layers and a plurality of conductive layers on the substrate, the manufacturing method further includes: etching edges of the plurality of dielectric layers and the plurality of conductive layers, where the plurality of conductive layers are arranged in a stepped shape in a direction away from the substrate, and in two adjacent conductive layers, an orthographic projection, on the substrate, of a conductive layer away from the substrate is located within a boundary of an orthographic projection, on the substrate, of a conductive layer close to the substrate.

Such a design is intended to facilitate electrical connection of the capacitor to a bonding structure through the conductive channel.

In an implementation, after the etching edges of the plurality of dielectric layers and the plurality of conductive layers, for the plurality of conductive layers to be arranged in the stepped shape, the manufacturing method further includes: disposing the first conductive channel at an edge of each conductive layer, for the conductive layer to be capable of being electrically connected to the solder joint through the first conductive channel.

According to yet another aspect, this application further provides an electronic device. The electronic device includes a processor and the memory according to any one of the foregoing implementations. The processor is electrically connected to the memory, and the memory is configured to store data generated by the processor.

The electronic device provided in this embodiment of this application includes the memory according to any one of the foregoing implementations. Therefore, the electronic device provided in this embodiment of this application and the memory in the foregoing technical solutions can resolve a same technical problem and achieve same expected effect.

### BRIEF DESCRIPTION OF DRAWINGS

FIG. 1A to FIG. 1C are diagrams of structures of CMOS next array (CnA) 3D memories in a related technology;
FIG. 2 is a diagram of a structure of a CMOS under array (CuA) 3D memory in a related technology;
FIG. 3 is a circuit diagram of an electronic device according to an embodiment of this application;
FIG. 4 is a simple circuit diagram of a memory according to an embodiment of this application;
FIG. 5 is a circuit diagram of a memory according to an embodiment of this application;
FIG. 6 is a diagram of how to manufacture a memory according to an embodiment of this application;
FIG. 7 is a diagram of a process structure of a memory according to an embodiment of this application;
FIG. 8A is a diagram of a process structure of a control circuit chip according to an embodiment of this application;
FIG. 8B is a diagram of a process structure of a memory array chip according to an embodiment of this application;
FIG. 8C is a diagram of a process structure of a memory according to an embodiment of this application;
FIG. 9 is a circuit diagram of a memory cell in a memory according to an embodiment of this application;
FIG. 10 is a circuit diagram of a memory array chip according to an embodiment of this application;
FIG. 11A is a diagram of a process structure of a memory array chip according to an embodiment of this application;
FIG. 11B is an enlarged view of a position A in FIG. 11A;
FIG. 11C is a diagram of a process structure of a memory cell according to an embodiment of this application;
FIG. 11D is a diagram of a process structure of a memory array chip according to an embodiment of this application;
FIG. 12A is a 3-dimensional view of a transistor according to an embodiment of this application;
FIG. 12B is an M-M cross-sectional view of FIG. 12A;
FIG. 13 is a block flowchart of a memory manufacturing method according to an embodiment of this application;
FIG. 14A to FIG. 14F are diagrams of corresponding structures obtained by completing each step in a manufacturing procedure of a memory array chip according to an embodiment of this application; and
FIG. 15A to FIG. 15F are diagrams of corresponding structures obtained by completing each step in a manufacturing procedure of a gate-all-around transistor according to an embodiment of this application.

Reference numerals:
100: electronic device;
210: SoC; 211: application processor; 212: GPU; 213: second memory; 205: bus; 220: first memory; 230: communication chip; and 240: power management chip;
300: memory;
31: memory array chip;
32: control circuit chip;
33: bonding structure;
311: first substrate;
312: storage layer;
321: second substrate;
322: circuit structure;
331: first solder joint;
332: second solder joint;
400: memory cell;
501 and 601: dielectric layer;
502: first capacitor electrode;
503: capacitive layer;
504: second capacitor electrode and second electrode;
505: channel layer;
506: first electrode;
507: gate dielectric layer;
508: gate; and
602: conductive layer.

### DESCRIPTION OF EMBODIMENTS

The following describes in detail content in embodiments of this application with reference to the accompanying drawings.

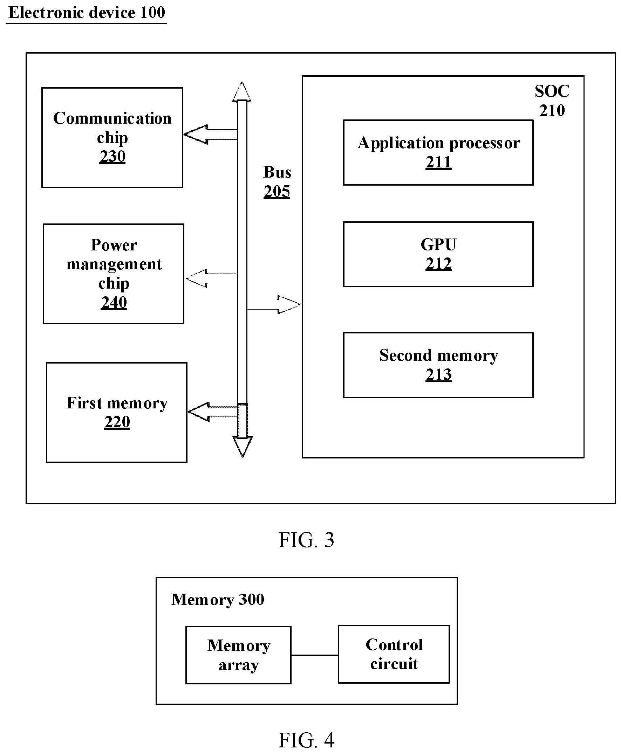

An embodiment of this application provides an electronic device including a memory. FIG. 3 is a block diagram of a circuit in an electronic device 100 according to an embodiment of this application. The electronic device 100 may be a terminal device, for example, a mobile phone, a tablet computer, or a smart band, or may be a personal computer (personal computer, PC), a server, a workstation, or the like.

Refer to FIG. 3. The electronic device 100 includes a bus 205, and a system on chip (system on chip, SoC) 210 and a first memory 220 that are connected to the bus 205. The SoC 210 may be configured to process data, for example, process data of an application, process image data, and buffer temporary data. The first memory 220 may be configured to store non-volatile data, for example, an audio file or a video file. The first memory 220 may be a programmable read-only memory (programmable read-only memory, PROM), an erasable programmable read-only memory (erasable programmable read-only memory, EPROM), a flash memory (flash memory), or the like.

In addition, the electronic device 100 may further include a communication chip 230 and a power management chip 240. The communication chip 230 may be configured to process a protocol stack, or perform processing such as amplification and filtering on an analog radio frequency signal, or implement all the foregoing functions. The power management chip 240 may be configured to supply power to another chip.

In an implementation, the SoC 210 may include an application processor (application processor, AP) 211 configured to process an application, a graphics processing unit (graphics processing unit, GPU) 212 configured to process image data, and a second memory 213.

The AP 211, the GPU 212, and the second memory 213 may be integrated into one die (die), or may be respectively integrated into a plurality of dies (dies) and packaged in a packaging structure through 2.5D (dimension) packaging or 3D packaging, another advanced packaging technology, or the like. In an implementation, the AP 211 and the GPU 212 are integrated into one die, the second memory 213 is integrated into another die, and the two dies are packaged in a packaging structure, to obtain a higher inter-die data transmission rate and a higher data transmission bandwidth. FIG. 4 is a block diagram of a circuit of a memory 300 that may be used in an electronic device according to an embodiment of this application. In an implementation, the memory 300 may be a ferroelectric random access memory (Ferroelectric Random Access Memory, FeRAM or FRAM), or may be a dynamic random access memory (dynamic random access memory, DRAM). An application scenario of the memory 300 is not limited in this application.

As shown in FIG. 4, the memory 300 includes a memory array and a control circuit configured to access the memory array. The control circuit is configured to control a reading/writing operation on the memory array.

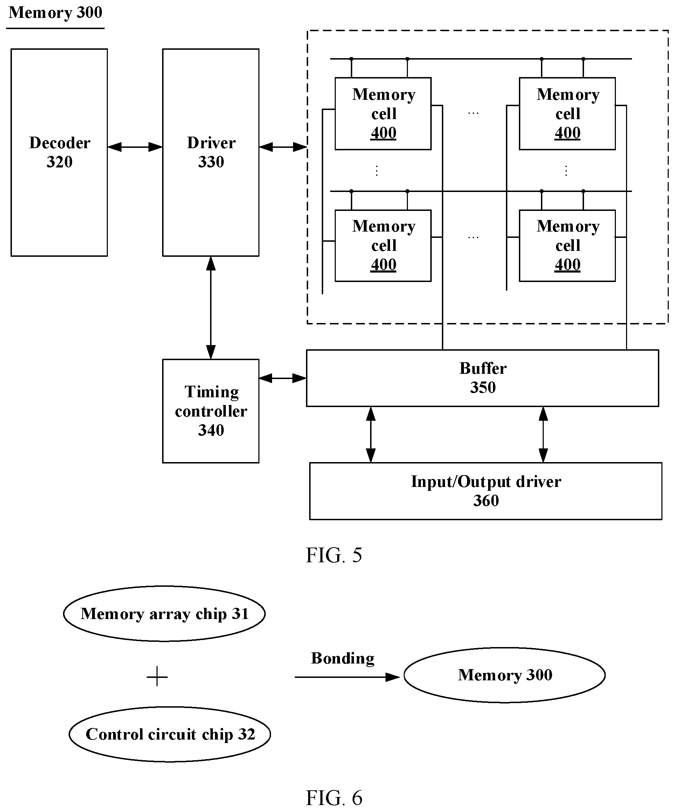

In an implementation, the memory array in the memory may include a plurality of memory cells 400 arranged in an array shown in FIG. 5, where each memory cell 400 may be configured to store one-bit (bit) or multi-bit data. The memory array may further include electrode lines such as a word line (word line, WL) and a bit line (bit line, BL). Each memory cell 400 is electrically connected to a corresponding word line WL and a corresponding bit line BL. One or more of the word line WL and the bit line BL are configured to select, by receiving a control level output by the control circuit, a to-be-read/to-be-written memory cell 400 in the memory array, to implement a data reading/writing operation.

The control circuit in the memory may include a circuit structure of one or more of a decoder 320, a driver 330, a timing controller 340, a buffer 350, or an input/output driver 360 shown in FIG. 5.

In a structure of the memory 300 shown in FIG. 5, the decoder 320 is configured to perform decoding based on a received address, to determine a memory cell 400 that needs to be accessed. The driver 330 is configured to control a level of a signal line based on a decoding result generated by the decoder 320, to implement access to a specified memory cell 400. The buffer 350 is configured to buffer read data, for example, may buffer the data in a first-in first-out (first-in first-out, FIFO) manner. The timing controller 340 is configured to control a timing of the buffer 350 and control the driver 330 to drive the signal line in the memory array. The input/output driver 360 is configured to drive a transmission signal, for example, drive a received data signal and drive a data signal that needs to be sent, so that the data signals can be communicated over a long distance.

The memory array may be integrated into one chip. The decoder 320, the driver 330, the timing controller 340, the buffer 350, and the input/output driver 360 may be integrated into another chip.

For example, as shown in FIG. 6, the memory array is integrated into one chip to form a memory array chip 31, the control circuit is integrated into another chip to form a control circuit chip 32, and then the memory array chip 31 and the control circuit chip 32 are bonded, to form a multiple-chip-stacked memory 300 including the memory array chip 31 and the control circuit chip 32.

In embodiments of this application, for example, the memory array chip 31 or the control circuit chip 32 may be a wafer wafer, or may be a die die cut from a wafer wafer.

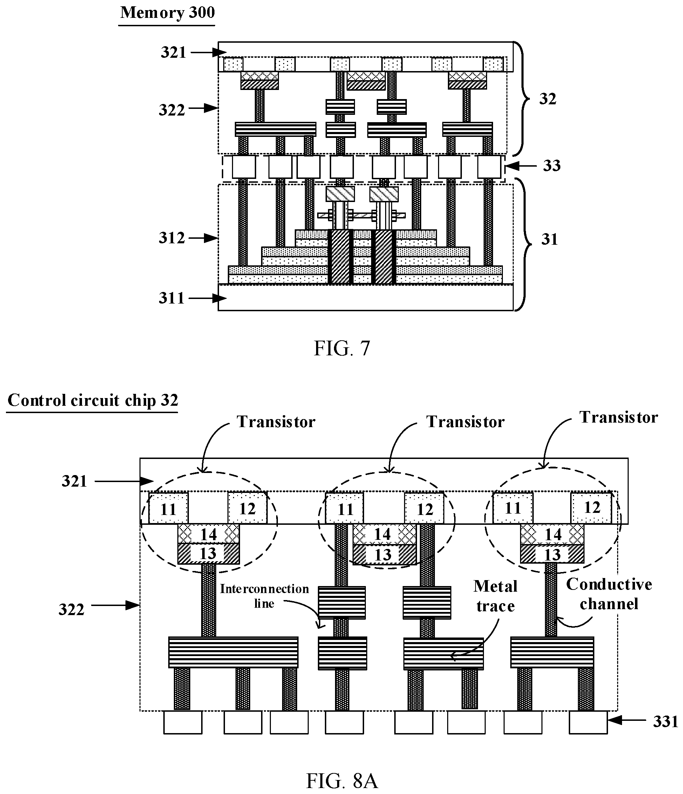

FIG. 7 is a diagram of a process structure of the memory 300 according to an embodiment of this application. The memory 300 includes the memory array chip 31 and the control circuit chip 32. The memory array chip 31 includes a first substrate 311 and a storage layer 312 formed on a side of the first substrate 311. The storage layer 312 includes a plurality of memory cells 400 shown in FIG. 5. The control circuit chip 32 includes a second substrate 321 and a circuit structure 322 formed on a side of the second substrate 321.

In addition, as shown in FIG. 7, the storage layer 312 is close to the circuit structure 322 relative to the first substrate 311, and the circuit structure 322 is close to the storage layer 312 relative to the second substrate 321. In other words, the storage layer 312 and the circuit structure 322 face each other. There is a bonding structure 33 between the storage layer 312 and the circuit structure 322. The storage layer 312 and the circuit structure 322 are physically and electrically connected to each other through the bonding structure 33, so that the circuit structure 322 controls reading/writing of the memory cell in the storage layer 312 through the bonding structure 33.

FIG. 8A shows an example of a diagram of a process structure of the control circuit chip 32. A plurality of transistors are integrated on the second substrate 321 of the control circuit chip 32. For example, in FIG. 8A, three transistors are shown as an example, and these transistors are all manufactured through a front end of line process. For example, each transistor includes a source doped region 11 and a drain doped region 12 that are formed by performing doping injection in the second substrate 321. A channel region is formed between the source doped region 11 and the drain doped region 12 of the second substrate 321, a gate 13 is formed above the channel region, and the gate 13 is isolated from the channel region by a gate dielectric layer 14.

In some examples, a passive device, for example, a resistor, a capacitor, or an inductor, may be further formed on the second substrate 321. Active devices: transistors are connected to passive devices: resistors, capacitors, or inductors through interconnection lines shown in FIG. 8A, to form the circuit structure 322. The circuit structure 322 may be configured to control reading/writing of the memory cell in the memory array chip 31.

In FIG. 8A, to clearly show the transistor and the interconnection line that are integrated on the second substrate 321, an interlayer medium is not shown. In an actual product, in FIG. 8A, both a metal trace and a conductive channel configured to electrically connect to different metal traces are formed in the interlayer medium. The interlayer medium may be of one layer or may be formed by stacking a plurality of layers.

Still refer to FIG. 8A. A plurality of solder joints 331 are formed on a side that is of the circuit structure 322 and that is away from the second substrate 321, and these solder joints 331 are electrically connected to the circuit structure 322. In this case, a signal of the circuit structure 322 may communicate with a peripheral circuit through the solder joint 331.

For example, a plurality of materials may be selected for the solder joint 331, for example, at least one of Cu, NiSi, and NiPtSi may be selected.

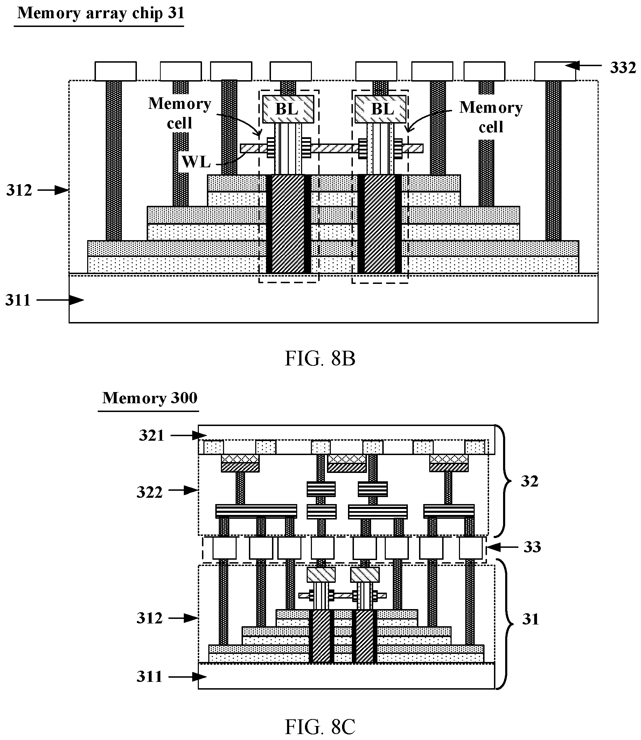

FIG. 8B shows an example of a diagram of a process structure of the memory array chip 31. In FIG. 8B, two memory cells are shown as an example, and the two memory cells are arranged in a direction parallel to the first substrate 311. In addition, in FIG. 8B, a word line (word line, WL) and a bit line (bit line, BL) are further shown. The word line WL and the bit line BL are electrically connected to the memory cell. The following describes in detail a circuit structure and a process structure of the memory cell in this application with reference to the accompanying drawings.

Still refer to FIG. 8B. A plurality of solder joints 332 are formed on a side that is of the storage layer 312 and that is away from the first substrate 311, and the solder joints 332 are electrically connected to the storage layer 312.

In some examples, a plurality of materials may be selected for the solder joint 332. For example, at least one of Cu, NiSi, and NiPtSi may be selected.

As shown in FIG. 8A and FIG. 8B, the circuit structure 322 in the control circuit chip 32 faces the storage layer 312 in the memory array chip 31, and the solder joints 331 and the solder joints 332 are bonded together to form the bonding structure 33 in FIG. 8C. For clear description, the solder joint 331 on the memory array chip 31 may be referred to as a first solder joint, and the solder joint 332 on the control circuit chip 32 may be referred to as a second solder joint.

After the memory array chip 31 and the control circuit chip 32 are bonded according to FIG. 8A, FIG. 8B, and FIG. 8C, the storage layer 312 may be electrically connected to the circuit structure 322 through the bonding structure 33, so that the circuit structure 322 controls reading/writing of the memory cell.

It can be learned from FIG. 8A to FIG. 8C that the memory 300 provided in this embodiment of this application is formed by stacking, through the bonding structure 33, a first chip formed by the memory array chip 31 and a second chip formed by the control circuit chip 32, to form a multiple-chip-3D-stacked structure.

According to the memory 300 shown in FIG. 8C provided in this embodiment of this application, the memory array chip 31 is stacked with the control circuit chip 32, and an active surface (a surface including the memory cell) of the memory array chip 31 is opposite to an active surface (a surface including the circuit structure) of the control circuit chip 32. Therefore, this structure may be referred to as a wafer on wafer-face to face (WoW-F2F) 3D storage architecture.

Compared with a CMOS next array (CnA) 3D memory structure in a related technology, in the WoW-F2F 3D storage architecture in this embodiment of this application, a 2-dimensional area occupied by the control circuit chip does not increase with an increase in a quantity of stacked layers of memory cells in the memory array chip. Therefore, the memory shown in FIG. 8C results in a smaller 2-dimensional area of a chip while improving a storage density.

The "2-dimensional area of a chip" in embodiments of this application may be understood as an area parallel to a substrate, for example, an area occupied in an X-Y plane.

When the WoW-F2F 3D storage architecture shown in FIG. 8C is manufactured, the memory array chip 31 and the control circuit chip 32 may be separately manufactured through manufacturing processes independent of each other, and then the two chips are bonded together through a bonding process.

Then, first, when the memory array chip 31 and the control circuit chip 32 are separately manufactured, the manufacturing process of the memory array chip 31 and the manufacturing process of the control circuit chip 32 may be incompatible, and do not interfere with each other. Compared with a process of a CMOS under array (CuA) 3D memory structure in a related technology, in this process, a process of the CMOS is decoupled from a process of the array. In this way, for example, a high-temperature process for manufacturing the memory cell in the memory array chip 31 does not affect performance of the control circuit chip 32, so that respective performance can be ensured. In addition, when the two chips are bonded, a hybrid bonding process may be used. A bonding temperature is not higher than 450°C. For example, the bonding temperature is lower than or equal to 400°C, and the temperature basically does not affect performance of the formed memory cell and performance of the circuit structure.

A CMOS-wafer and an array-wafer can be designed and manufactured independently, to eliminate process incompatibility and restriction and increase a yield rate. Therefore, most advanced processes may be separately used for a CMOS and an array, and a case in which performance of the array and performance of theCMOS restrict each other due to impact on the CMOS caused by a high-temperature manufacturing process of the array does not occur. An advanced high-temperature process may be used for the array to achieve better component performance. An advanced logic process may be selected for the CMOS to achieve a high transmission speed, regardless of the impact caused by the high-temperature process of the array.

In addition, a structure for connecting the memory array chip 31 to the control circuit chip 32 is the bonding structure 33. The bonding structure 33 may be manufactured through the hybrid bonding process. The process is simple, and a case in which some special materials are selected as a material of the bonding structure due to consideration for compatibility between the manufacturing process of the memory array chip 31 and the manufacturing process of the control circuit chip 32 does not occur. Therefore, a wide range of materials are selected for the bonding structure 33 in this application. For example, Cu, NiSi, NiPtSi, and the like with low resistance may be selected. When a material with low resistance is selected as the material of the bonding structure, a rate of signal transmission between the control circuit chip 32 and the memory array chip 31 is basically not affected.

The memory 300 in this embodiment of this application may be a dynamic random access memory (dynamic random access memory, DRAM), for example, may be a DRAM including a 1TnC memory cell.

In addition, the memory 300 in this embodiment of this application may alternatively be a ferroelectric random access memory (ferroelectric random access memory, FeRAM), for example, may be an FeRAM including a 1TnC memory cell.

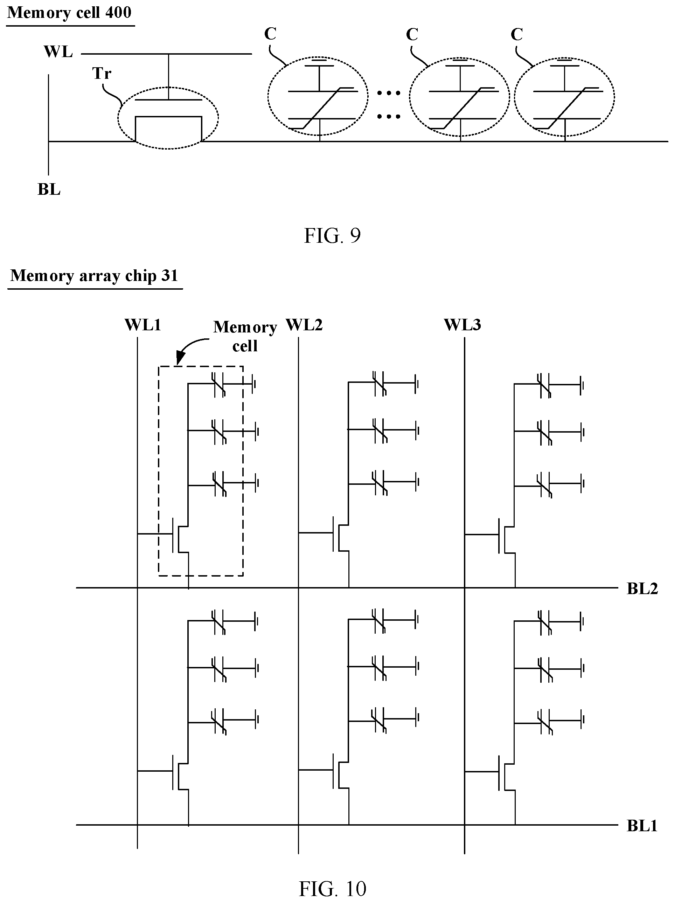

FIG. 9 is a circuit diagram of a memory cell 400 in the memory 300 according to an embodiment of this application. As shown in FIG. 9, the memory cell 400 belongs to a 1TnC gain-cell memory cell structure, in other words, one memory cell 400 includes one transistor Tr and a plurality of capacitors C. For example, FIG. 9 shows an example in which one memory cell 400 includes one transistor Tr and three capacitors. Certainly, in some embodiments, one memory cell may include two or more capacitors.

As shown in FIG. 9, one electrode (either a source or a drain) of the transistor Tr is electrically connected to a bit line (bit line, BL), another electrode (the other of the source and the drain) of the transistor Tr is electrically connected to one capacitor electrode of the plurality of capacitors C, and a gate of the transistor Tr is electrically connected to a word line (word line, WL); and another capacitor electrode of the plurality of capacitors C is electrically connected to a plate line (plate line, PL), for example, the capacitor electrode is grounded to the plate line.

For example, the memory cell shown in FIG. 9 may be an FeRAM memory cell, in other words, a capacitive layer formed between a first capacitor electrode and a second capacitor electrode is a ferroelectric material layer. Certainly, the memory cell shown in FIG. 9 may alternatively be a DRAM memory cell.

For example, when the memory cell shown in FIG. 9 is an FeRAM memory cell, in a write phase, the word line WL is configured to receive a word line control signal, to conduct the transistor Tr, the bit line BL is configured to receive a bit line control signal, the plate line PL electrically connected to the ferroelectric capacitor is configured to receive a plate line control signal, and a voltage difference between the bit line control signal and the plate line control signal causes positive polarization or negative polarization at a ferroelectric layer of a selected ferroelectric capacitor, to write different logic information into the selected ferroelectric capacitor. For example, when the positive polarization occurs at the ferroelectric layer, a logic signal "0" is written. For another example, when the negative polarization occurs at the ferroelectric layer, a logic signal "1" is written.

In embodiments of this application, for example, the transistor Tr shown in FIG. 9 may be an NMOS (N-channel metal oxide semiconductor, N-channel metal oxide semiconductor) transistor, or may be a PMOS (P-channel metal oxide semiconductor, P-channel metal oxide semiconductor) transistor.

In addition, in embodiments of this application, either the drain (drain) or the source (source) of the transistor Tr is referred to as a first electrode, and the corresponding other electrode is referred to as a second electrode. A control end of the transistor is the gate. The drain and the source of the transistor may be determined based on a flow direction of a current.

When the memory cell in FIG. 8C includes the transistor Tr shown in FIG. 9 and the plurality of capacitors C electrically connected to the transistor Tr, a circuit structure of the memory array chip 31 in FIG. 8C may be shown in FIG. 10. Refer to FIG. 10. Gates of transistors Tr of a plurality of memory cells arranged in a same direction may be electrically connected to a same word line WL, and second electrodes of the transistors Tr of the plurality of memory cells arranged in the same direction may be electrically connected to a same bit line BL. In this way, a plurality of word lines WL and a plurality of bit lines BL are formed. In some examples, the circuit structure in FIG. 8A includes at least a row decoder and a column decoder. The row decoder is coupled to the word lines WL, and is configured to turn on or off a gate of the transistor Tr, and the column decoder is coupled to the bit line BL, and is configured to perform reading or writing on the memory cell.

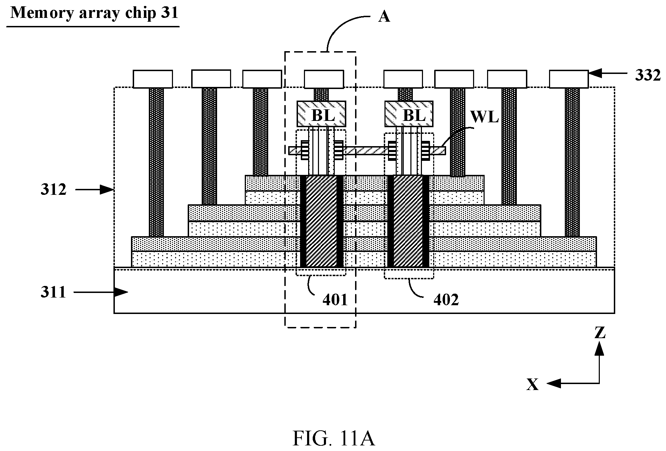

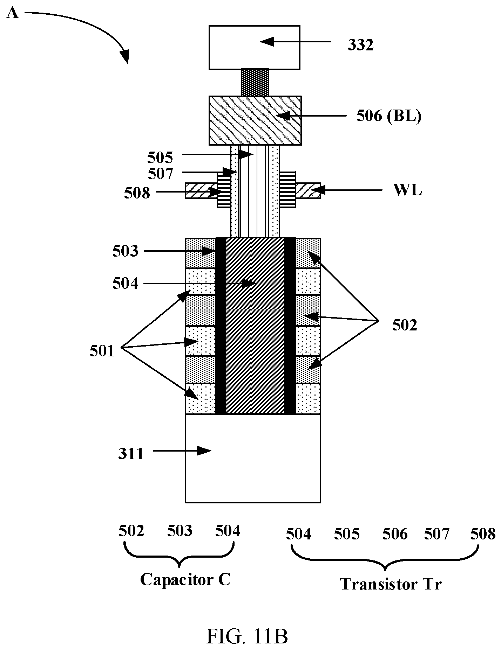

FIG. 11A and FIG. 11B show an example of a diagram of a process structure of a memory cell that may be used in the memory array chip 31. FIG. 11B is an enlarged view of a position A in FIG. 11A. Refer to FIG. 11B. In this embodiment, one memory cell includes one transistor Tr and a plurality of capacitors C, and the plurality of capacitors C and the transistor Tr are stacked in a direction perpendicular to the first substrate 311. The plurality of capacitors C are disposed close to the first substrate 311 relative to the transistor Tr, and the transistor Tr is disposed away from the first substrate 311 relative to the plurality of capacitors C.

Still as shown in FIG. 11B, each capacitor C includes a first capacitor electrode 502, a capacitive layer 503, and a second capacitor electrode 504. FIG. 11B shows three stacked capacitors C as an example. These capacitors C are stacked in the direction perpendicular to the first substrate 311, and these capacitors C share the same second capacitor electrode 504.

In an implementable process, dielectric layers 501 and first capacitor electrodes 502 that are alternately arranged may be first stacked on the first substrate 311, vias are formed in the stacked dielectric layers 501 and first capacitor electrodes 502, and the capacitive layer 503 and an electrode layer that are stacked are formed in the via, so that the capacitors C share the same second capacitor electrode 504.

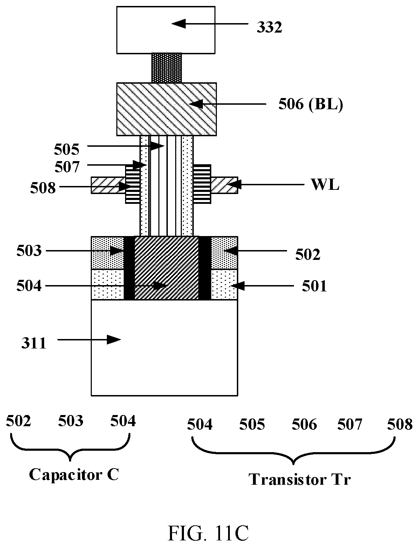

In some other embodiments, more capacitors C may be stacked based on the structure shown in FIG. 11B. Alternatively, as shown in FIG. 11C, one capacitor C and one transistor Tr are disposed in one memory cell. When the memory cell includes the transistor Tr and the capacitor C, a formed memory cell is referred to as a 1T1C memory cell.

With reference to FIG. 11B and FIG. 11C, the transistor Tr includes a first electrode 506, a second electrode 504, a channel layer 505, a gate dielectric layer 507, and a gate 508. The first electrode 506 and the second electrode 504 are arranged in the direction perpendicular to the first substrate 311. In some process structures, to simplify the process structures, the second electrode 504 of the transistor Tr and the second capacitor electrode 504 of the capacitor C may be a same electrode. In addition, the channel layer 505 is located between the first electrode 506 and the second electrode 504. A channel formed in this way may be referred to as a vertical channel perpendicular to the first substrate 311.

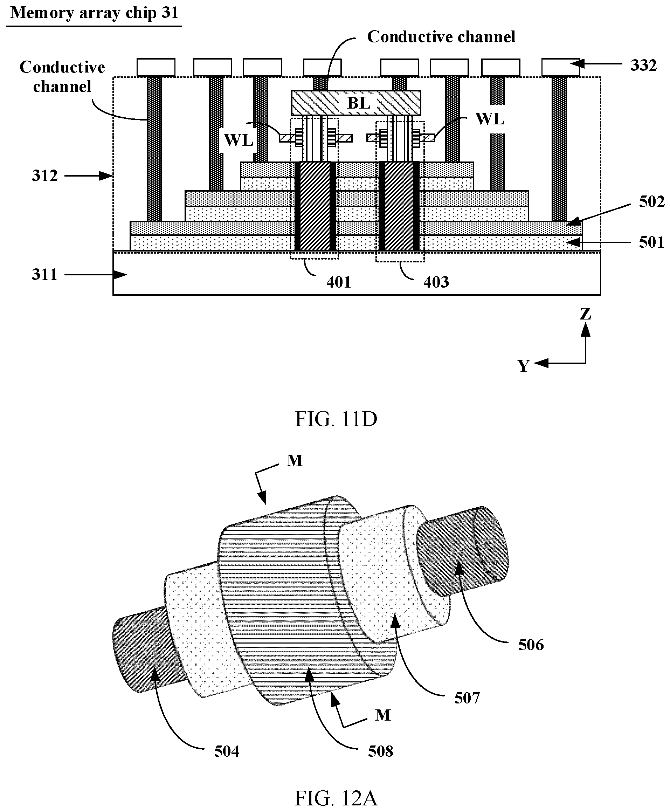

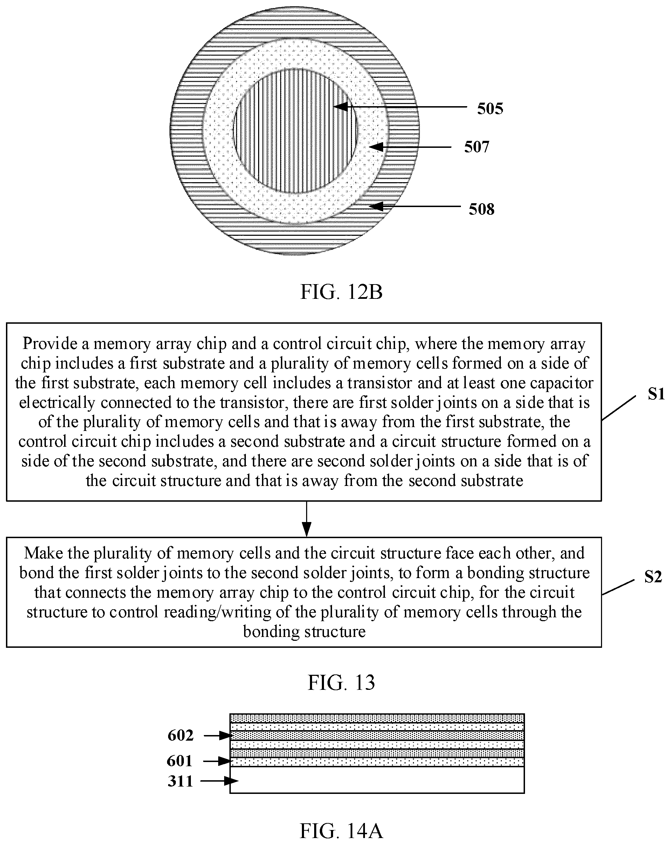

In addition, FIG. 12A and FIG. 12B are a diagram of a structure of the transistor Tr, and FIG. 12B is an M-M cross-sectional view of FIG. 12A. With reference to FIG. 12A and FIG. 12B, the gate 508 surrounds the channel layer 505, and the gate 508 is isolated from the channel layer 505 by the gate dielectric layer 507. The transistor Tr structure formed in this way may be referred to as a gate-all-around (Gate-All-Around, GAA) crystal transistor.

Further refer to FIG. 11B and FIG. 11C. The memory array chip 31 further includes a word line WL and a bit line BL. The word line WL is disposed around the gate 508, and the bit line BL and the first electrode 506 of the transistor Tr may share a same film layer.

As shown in FIG. 11A, a plurality of memory cells arranged in a first direction (for example, an X direction in FIG. 11A) may share a same word line WL, for example, a gate of a transistor in a first memory cell 401 arranged in the X direction and a gate of a transistor in a second memory cell 402 are electrically connected to a same word line WL, but a bit line BL electrically connected to the first memory cell 401 is electrically isolated from a bit line BL electrically connected to the second memory cell 402.

In addition, as shown in FIG. 11D, a plurality of memory cells arranged in a second direction (for example, a Y direction of FIG. 11D) may share a same bit line BL, for example, a second electrode of a transistor in a first memory cell 401 arranged in the Y direction and a second electrode of a transistor in a third memory cell 403 are electrically connected to a same bit line BL, but a word line WL of the first memory cell 401 is electrically isolated from a word line WL of the second memory cell 402.

Still refer to FIG. 11D. To electrically connect the memory cell to the solder joint 332, a conductive channel (for example, a through silicon via TSV) is disposed on a side that is of the bit line BL and that is away from the first substrate 311, and one end of the conductive channel is connected to the bit line BL, the other end is connected to the solder joint 332, that is, the memory cell is interconnected to the solder joint 332 through the conductive channel.

In addition, as shown in FIG. 11D, the first capacitor electrode 502 of the capacitor C is electrically connected to the solder joint 332 through a conductive channel (for example, a through silicon via TSV).

In FIG. 11A to FIG. 11D, to clearly show the memory cell integrated on the first substrate 311, an interlayer medium is not shown. In an actual product, the memory cell in FIG. 11D is formed in the interlayer medium. The interlayer medium may be of one layer or may be formed by stacking a plurality of layers.

Based on the foregoing memory cell structures, it can be learned that, in each memory cell in this embodiment of this application, the transistor Tr is disposed close to the solder joint, and the capacitor C is disposed close to the substrate. In this case, the transistor Tr may be electrically connected to the solder joint 332 through a simple electrical connection structure (for example, a conductive channel). In addition, one capacitor electrode of the capacitor is also electrically connected to the solder joint 332 through an electrical connection structure (for example, a conductive channel) with a simple structure. In conclusion, when the transistor Tr and the capacitor C are arranged according to FIG. 11A to FIG. 11D, structures in which both the transistor Tr and the capacitor C are electrically connected to the solder joint 332 are simple. In this way, a wiring structure of the entire memory array chip 31 is simplified, more accommodation space can be avoided for the memory cell through simplifying the wiring structure, to increase a quantity of memory cells, thereby improving a storage density and a storage capacity.

In the 1TnC or 1T1C memory cell provided in the foregoing embodiments, there are a plurality of materials that may be selected for each functional layer of the transistor Tr, each functional layer of the capacitor C, the word line WL, and the bit line BL. The following provides a part of materials that may be selected.

In the materials that may be selected, the first electrode, the second electrode, the gate electrode, the word line WL, and the bit line BL of the transistor Tr are all made from conductive materials, for example, metal materials. In an optional implementation, the materials may be one or more of conductive materials such as TiN (titanium nitride), Ti (titanium), Au (aurum), W (tungsten), Mo (molybdenum), In-Ti-O (ITO, indium tin oxide), Al (aluminum), Cu (copper), Ru (ruthenium), and Ag (silver).

In materials that may be selected, the channel layer 505 of the transistor Tr may be made from one or more of semiconductor materials such as Si (silicon), poly-Si (p-Si, polycrystalline silicon), amorphous-Si (a-Si, amorphous silicon), an In-Ga-Zn-O (IGZO, indium gallium zinc oxide) multi-compound, ZnO (zinc oxide), ITO (indium tin oxide), TiO₂ (titanium dioxide), MoS₂ (molybdenum disulfide), WS₂ (tungsten disulfide), graphene, and black phosphorus.

The gate dielectric layer 507 of the transistor Tr may be made from one or more of insulating materials such as SiO₂ (silicon dioxide), Al₂O₃ (aluminum oxide), HfO₂ (hafnium oxide), ZrO₂ (zirconium oxide), TiO₂ (titanium dioxide), Y₂O₃ (yttrium trioxide), and Si₃N₄ (silicon nitride).

Both the first capacitor electrode and the second capacitor electrode in the capacitor C are made from conductive materials. In materials that may be selected, the materials may be one or more of conductive materials such as TiN (titanium nitride), Ti (titanium), Au (aurum), W (tungsten), Mo (molybdenum), In-Ti-O (ITO, indium tin oxide), Al (aluminum), Cu (copper), Ru (ruthenium), and Ag (silver).

The capacitive layer in the capacitor C may be selected as or may be made from an insulating material, for example, SiO₂, Al₂O₃, HfO₂, ZrO₂, TiO₂, Y₂O₃, and Si₃N₄ or HAO, or a ferroelectric material, for example, ZrO₂, HfO₂, Al-doped HfO₂, Si-doped HfO₂, Zr-doped HfO₂, La-doped HfO₂, or Y-doped HfO₂, or a material obtained by doping another element based on the material, or any combination thereof.

The foregoing describes, with reference to the accompanying drawings, the memory including the memory array chip 31 and the control circuit chip 32 provided in embodiments of this application. The following describes in detail a manufacturing method provided in embodiments of this application with reference to the accompanying drawings, to manufacture the memory including the memory array chip 31 and the control circuit chip 32. For details, refer to the following descriptions.

FIG. 13 shows an example of a block flowchart of manufacturing a memory.

Step S1: Provide a memory array chip and a control circuit chip, where the memory array chip includes a first substrate and a plurality of memory cells formed on a side of the first substrate, each memory cell includes a transistor and at least one capacitor electrically connected to the transistor, there are first solder joints on a side that is of the plurality of memory cells and that is away from the first substrate, the control circuit chip includes a second substrate and a circuit structure formed on a side of the second substrate, and there are second solder joints on a side that is of the circuit structure and that is away from the second substrate.

To be specific, in this embodiment, the memory array chip and the control circuit chip may be respectively manufactured through mutually independent processes. This can avoid impact caused by incompatibility and mutual restriction of the processes. In this way, the storage array chip may be manufactured through an advanced process, and the control circuit chip may be manufactured through an advanced process.

In addition, in an implementable process, the memory array chip and the control circuit chip may be manufactured simultaneously, to shorten a manufacturing period of the memory.

Step S2: Make the plurality of memory cells and the circuit structure face each other, and bond the first solder joints to the second solder joints, to form a bonding structure that connects the memory array chip to the control circuit chip, for the circuit structure to control reading/writing of the plurality of memory cells through the bonding structure.

In this way, the circuit structure may be interconnected to the memory cell through the bonding structure, so that the control circuit chip controls a reading/writing operation on the memory cell.

The following describes specific process flows involved in the foregoing steps S1 and S2 with reference to the accompanying drawings.

FIG. 14A to FIG. 14F show process structures obtained by completing each step in a process procedure for manufacturing a memory array chip according to an embodiment of this application.

As shown in FIG. 14A, a plurality of dielectric layers 601 and a plurality of conductive layers 602 are stacked on a first substrate 311, and the plurality of dielectric layers 601 and the plurality of conductive layers 602 are alternately stacked.

These dielectric layers 601 may be made from one or more of insulating materials such as SiO₂ (silicon dioxide), Al₂O₃ (aluminum oxide), HfO₂ (hafnium oxide), ZrO₂ (zirconium oxide), TiO₂ (titanium dioxide), Y₂O₃ (yttrium trioxide), and Si₃N₄ (silicon nitride).

The conductive layer 602 may be made from one or more of conductive materials such as TiN (titanium nitride), Ti (titanium), Au (aurum), W (tungsten), Mo (molybdenum), In-Ti-O (ITO, indium tin oxide), Al (aluminum), Cu (copper), Ru (ruthenium), and Ag (silver).

A quantity of the dielectric layers 601 is equal to a quantity of the conductive layers 602. For example, when a 1T3C memory cell needs to be manufactured, three dielectric layers 601 and three conductive layers 602 may be alternately stacked. For another example, when a 1T1C memory cell needs to be manufactured, one dielectric layer 601 and one conductive layer 602 may be stacked.

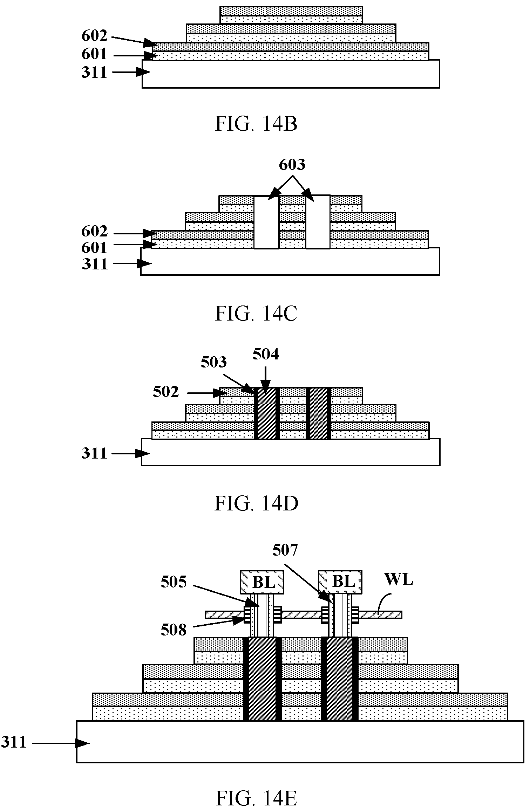

As shown in FIG. 14B, the plurality of dielectric layers 601 and the plurality of conductive layers 602 are etched, to form a stepped structure.

Specifically, as shown in FIG. 14B, the plurality of dielectric layers 601 and the plurality of conductive layers 602 may be divided into multiple groups of functional layers, and one dielectric layer 601 and one conductive layer 602 that are adjacent to each other are one group of functional layers. For example, when N dielectric layers 601 and N conductive layers 602 are included, N groups of functional layers may be included. In addition, in a direction away from the first substrate 311, dimensions of the N groups of functional layers in a first direction gradually decrease, to form a stepped shape, and dimensions of the dielectric layer 601 and the conductive layer 602 in each group of functional layers in the first direction are equal. The first direction is a direction parallel to the first substrate 311.

It may also be understood as that the plurality of conductive layers 602 are arranged in the stepped shape in the direction away from the first substrate 311, and in two adjacent conductive layers 602, an orthographic projection, on the first substrate 311, of a conductive layer 602 away from the first substrate 311 is located within a boundary of an orthographic projection, on the first substrate 311, of a conductive layer 602 close to the first substrate 311.

In this way, an outer edge of the conductive layer 602 close to the first substrate 311 protrudes from an outer edge of the conductive layer away from the first substrate 311.

As shown in FIG. 14C, vias 603 that penetrate the plurality of dielectric layers 601 and the plurality of conductive layers 602 are formed, and each via 603 penetrates till the first substrate 311.

As shown in FIG. 14D, each via 603 is sequentially filled with a capacitor material and a conductive material, to form a capacitive layer 503 and an electrode. An electrode formed by a conductive layer 602 may be referred to as a first capacitor electrode 502 of the capacitor, and an electrode located in the via is referred to as a second capacitor electrode 504 of the capacitor.

For example, when a ferroelectric capacitor needs to be manufactured, in FIG. 14D, the capacitor material that may be filled may be ferroelectric materials such as ZrO2, HfO2, Al-doped HfO2, Si-doped HfO2, Zr-doped HfO2, La-doped HfO2, and Y-doped HfO2.

As shown in FIG. 14E, a channel layer 505, a gate dielectric layer 507, and a gate 508 of a transistor Tr are formed, the gate 508 is disposed around the channel layer 505, and a word line WL and a bit line BL are formed.

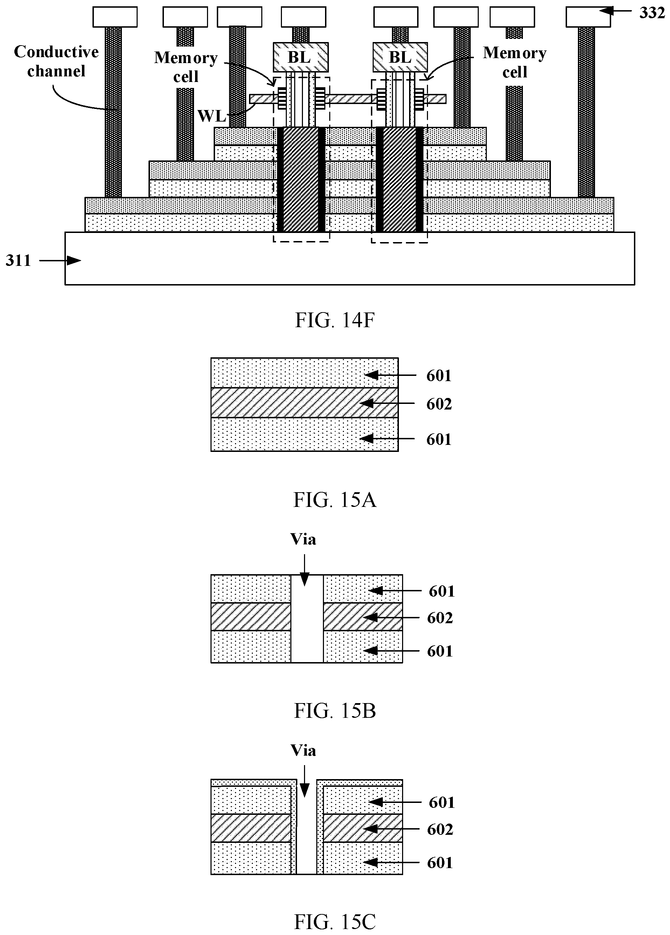

As shown in FIG. 14F, a conductive channel that penetrates an interlayer medium (not shown in the figure) is formed, and a solder joint 332 is formed, so that a first capacitor electrode of a capacitor C is electrically connected to the solder joint 332 through the conductive channel, and a bit line BL is electrically connected to the solder joint 332 through the conductive channel.

As shown in FIG. 14F, in FIG. 14B, the plurality of conductive layers are of a stepped structure. Therefore, the conductive channel may be disposed at an edge of the conductive layer, to avoid occupying space in which the memory cell is located.

FIG. 14A to FIG. 14F show examples of a structure of a memory array chip including a 1TnC memory cell. When the memory array chip is manufactured, there is no need to consider whether a process is compatible with a process for manufacturing a control circuit chip, and there is also no need to consider whether performance of the control circuit chip is affected. Therefore, such a memory array chip may be manufactured through an advanced process.

Similarly, the control circuit chip may be manufactured through an advanced process, and then the control circuit chip is bonded to the memory array chip manufactured in FIG. 14A to FIG. 14F, to manufacture a 3-dimensional stacked memory structure.

When the gate-all-around transistor shown in FIG. 14F is manufactured, the following process flows shown in FIG. 15A to FIG. 15F may be used.

As shown in FIG. 15A, a dielectric layer 601, a conductive layer 602, and a dielectric layer 601 that are sequentially stacked are formed.

As shown in FIG. 15B, vias that penetrate the dielectric layer 601, the conductive layer 602, and the dielectric layer 601 are formed.

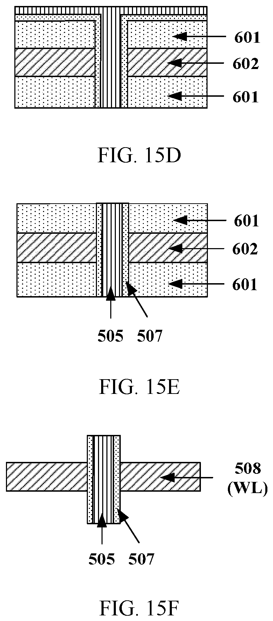

As shown in FIG. 15C and FIG. 15D, a gate dielectric material and a channel material are sequentially deposited in the via. In some implementation processes, as shown in FIG. 15C and FIG. 15D, a gate dielectric material and a channel material are also deposited on a surface of the dielectric layer 601 located above the conductive layer 602. As shown in FIG. 15E, the gate dielectric material and the channel material on the surface of the dielectric layer 601 located above the conductive layer 602 are removed.

As shown in FIG. 15F, dielectric layers located on two sides of the conductive layer 602 are removed, and the conductive layer 602 surrounds the channel layer 505 to form a gate-all-around structure. The conductive layer 602 may be used as a gate 508 of a transistor, and may also be used as a word line WL in a memory array chip.

FIG. 15A to FIG. 15F show an example of a gate-all-around transistor manufacturing method. The gate-all-around transistor in this embodiment of this application may alternatively be manufactured through another manufacturing process.

In the descriptions of this specification, specific features, structures, materials, or characteristics may be combined in a proper manner in any one or more embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A memory, comprising:
a memory array chip, comprising a first substrate and a plurality of memory cells formed on a side of the first substrate;
a control circuit chip, comprising a second substrate and a circuit structure formed on a side of the second substrate, wherein the circuit structure is configured to control reading/writing of the plurality of memory cells; and
a bonding structure, wherein the plurality of memory cells and the circuit structure face each other and are electrically connected to each other through the bonding structure formed between the circuit structure and the plurality of memory cells;
each memory cell comprises a transistor and at least one capacitor electrically connected to the transistor; and
the transistor and the at least one capacitor are stacked in a direction perpendicular to the first substrate, and the transistor is disposed close to the bonding structure relative to the at least one capacitor.

2. The memory according to claim 1, wherein a first conductive channel perpendicular to the first substrate is disposed on a periphery of the at least one capacitor, and each capacitor is electrically connected to the bonding structure through the first conductive channel.

3. The memory according to claim 2, wherein each memory cell comprises a plurality of capacitors, and each capacitor comprises a first capacitor electrode, a capacitive layer, and a second capacitor electrode;
a plurality of dielectric layers and a plurality of conductive layers are alternately stacked on the first substrate in the direction perpendicular to the first substrate;
the second capacitor electrode penetrates the plurality of dielectric layers and the plurality of conductive layers that are alternately stacked, to form a common second capacitor electrode of the plurality of capacitors;
the capacitive layer penetrates the plurality of dielectric layers and the plurality of conductive layers that are alternately stacked, to form a common capacitive layer of the plurality of capacitors, wherein the common capacitive layer surrounds the common second capacitor electrode; and
at least a part of the conductive layer surrounding a periphery of the capacitive layer forms the first capacitor electrode, wherein each first capacitor electrode is electrically connected to the bonding structure through the first conductive channel.

4. The memory according to claim 3, wherein first capacitor electrodes of a plurality of capacitors arranged in parallel to the first substrate are integrated.

5. The memory according to claim 3 or 4, wherein the plurality of conductive layers are arranged in a stepped shape in a direction away from the first substrate, and in two adjacent conductive layers, an orthographic projection, on the first substrate, of a conductive layer away from the first substrate is located within a boundary of an orthographic projection, on the first substrate, of a conductive layer close to the first substrate; and
the first conductive channel is disposed at an edge of the conductive layer.

6. The memory according to any one of claims 1 to 5, wherein a side that is of the transistor and that is close to the bonding structure has a second conductive channel perpendicular to the first substrate, and the transistor is electrically connected to the bonding structure through the second conductive channel.

7. The memory according to claim 6, wherein the memory array chip further comprises a first electrode line and a second electrode line, wherein the first electrode line is electrically connected to a gate of the transistor, the second electrode line is electrically connected to a first electrode of the transistor, and a second electrode of the transistor is electrically connected to the capacitor.

8. The memory according to claim 7, wherein the first electrode and the second electrode of the transistor are arranged in the direction perpendicular to the first substrate, a channel layer of the transistor is located between the first electrode and the second electrode, the first electrode is disposed away from the capacitor relative to the second electrode, the second electrode line and the first electrode share a same electrode layer, and the second electrode line is electrically connected to the bonding structure through the second conductive channel.

9. The memory according to any one of claims 1 to 8, wherein first solder joints are formed on a side that is of the plurality of memory cells and that is away from the first substrate, second solder joints are formed on a side that is of the circuit structure and that is away from the second substrate, and the first solder joints and the second solder joints are bonded to form the bonding structure.

10. The memory according to any one of claims 1 to 9, wherein the memory array chip is a DRAM memory array chip, or the memory array chip is a ferroelectric memory array chip.

11. A memory manufacturing method, wherein the manufacturing method comprises:
providing a memory array chip and a control circuit chip, wherein the memory array chip comprises a first substrate and a plurality of memory cells formed on a side of the first substrate, each memory cell comprises a transistor and at least one capacitor electrically connected to the transistor, there are first solder joints on a side that is of the plurality of memory cells and that is away from the first substrate, the control circuit chip comprises a second substrate and a circuit structure formed on a side of the second substrate, and there are second solder joints on a side that is of the circuit structure and that is away from the second substrate; and
making the plurality of memory cells and the circuit structure face each other, and bonding the first solder joints to the second solder joints, to form a bonding structure that connects the memory array chip to the control circuit chip, for the circuit structure to control reading/writing of the plurality of memory cells through the bonding structure.

12. The memory manufacturing method according to claim 11, wherein the first solder joint and the second solder joint are bonded through a hybrid bonding Hybrid Bonding process.

13. The memory manufacturing method according to claim 11 or 12, wherein when the first solder joint is bonded to the second solder joint, a bonding temperature is lower than or equal to 450°C.

14. A memory array chip manufacturing method, wherein the manufacturing method comprises:
forming at least one capacitor on a substrate;
forming a transistor on a side that is of the at least one capacitor and that is away from the substrate, wherein each memory cell in a memory array chip comprises the at least one capacitor and the transistor;
forming a first conductive channel perpendicular to the substrate on a periphery of the at least one capacitor, and forming a second conductive channel perpendicular to the substrate on a side that is of the transistor and that is away from the substrate; and
forming a solder joint on a side that is of the memory cell and that is away from the substrate, for the at least one capacitor to be electrically connected to the solder joint through the first conductive channel, and for the transistor to be electrically connected to the solder joint through the second conductive channel.

15. The memory array chip manufacturing method according to claim 14, wherein the forming at least one capacitor on the substrate comprises:
alternately stacking a plurality of dielectric layers and a plurality of conductive layers on the substrate;
forming vias that penetrate the plurality of dielectric layers and the plurality of conductive layers; and
sequentially filling the via with a capacitor material and an electrode material, to form a capacitive layer and a capacitor electrode in the via, wherein the capacitive layer is formed between the capacitor electrode and a side wall of the via, to manufacture a plurality of capacitors, the capacitive layer forms a common capacitive layer of the plurality of capacitors, the capacitor electrode forms a common second capacitor electrode of the plurality of capacitors, and at least a part of the conductive layer surrounding a periphery of the capacitive layer forms a first capacitor electrode of the capacitor.

16. The memory array chip manufacturing method according to claim 15, wherein after the alternately stacking the plurality of dielectric layers and the plurality of conductive layers on the substrate, the manufacturing method further comprises:
etching edges of the plurality of dielectric layers and the plurality of conductive layers, wherein the plurality of conductive layers are arranged in a stepped shape in a direction away from the substrate, and in two adjacent conductive layers, an orthographic projection, on the substrate, of a conductive layer away from the substrate is located within a boundary of an orthographic projection, on the substrate, of a conductive layer close to the substrate.

17. The memory array chip manufacturing method according to claim 16, wherein after the etching edges of the plurality of dielectric layers and the plurality of conductive layers, for the plurality of conductive layers to be arranged in the stepped shape, the manufacturing method further comprises:
disposing the first conductive channel at an edge of each conductive layer, for the conductive layer to be capable of being electrically connected to the solder joint through the first conductive channel.

18. An electronic device, comprising:
a processor; and
the memory according to any one of claims 1 to 10, or a memory manufactured by using the memory manufacturing method according to any one of claims 11 to 13, wherein
the memory is configured to store data generated by the processor.
